Europäisches Patentamt

European Patent Office

Office européen des brevets

(11) Veröffentlichungsnummer: **0 440 945 A2**

## (12) EUROPÄISCHE PATENTANMELDUNG

(21) Anmeldenummer: 90124413.7

(51) Int. Cl.5: **B32B 31/20**

(22) Anmeldetag: 17.12.90

(30) Priorität: 03.02.90 DE 4003157

(43) Veröffentlichungstag der Anmeldung:
14.08.91 Patentblatt 91/33

(84) Benannte Vertragsstaaten:
AT BE CH DE ES FR GB IT LI NL SE

(71) Anmelder: FERROZELL GMBH
Theodor-Sachs-Strasse 1
W-8900 Augsburg 22(DE)

(72) Erfinder: Hitzer, Hannelore, Dr. Dipl.-Chem.
Breitenbergweg 30
W-8901 Deuringen(DE)
Erfinder: Hienle, Johann, Ing.(grad.)
Waidmannstrasse 23
W-8900 Augsburg 28(DE)

(74) Vertreter: Cohausz & Florack Patentanwälte
Postfach 14 01 61 Schumannstrasse 97
W-4000 Düsseldorf 1(DE)

(54) Verfahren zum Verpressen von Paketen aus mit härtbarem Kunstharz getränkten Materiallagen zu Platten unter Verwendung von Druckausgleichspolstern und Druckausgleichpolster für die Durchführung des Verfahrens.

(57) Die Erfindung bezieht sich auf ein Verfahren zum Verpressen von Paketen aus mit härtbarem Kunststoff getränkten Materiallagen 4,5 zwischen Preßblechen 9,10 und durch Zufuhr von Wärme. Zwischen den Preßblechen 9,10 und Heizplatten 1,2 einer Heizpresse sind während des Verpressens Druckausgleichspolster 9,10 aus einem einlagigen Doppelstoff aus Baumwolle angeordnet. Nach mehrmaligem Gebrauch wird dieser Doppelstoff als Zwischenlage 6 im Paket eingesetzt und zusammen mit den mit härtbarem Kunstharz getränkten Materiallagen 4,5 unter Zufuhr von Wärme verpreßt.

EP 0 440 945 A2

**VERFAHREN ZUM VERPRESSEN VON PAKETEN AUS MIT HÄRTBAREM KUNSTHARZ GETRÄNKTEN MATERIALLAGEN ZU PLATTEN UNTER VERWENDUNG VON DRUCKAUSGLEICHSPOLSTERN UND DRUCK-AUSGLEICHSPOLSTER FÜR DIE DURCHFÜHRUNG DES VERFAHRENS**

Die Erfindung bezieht sich auf ein Verfahren zum Verpressen von Paketen aus mit härtbarem Kunstharz getränkten Materiallagen und gegebenenfalls einer oder zwei Decklagen aus Kupferfolie zwischen mit Druckausgleichspolstern versehenen Preßblechen unter Zufuhr von Wärme zu Platten.

Um bei einem solchen Verfahren Paketoberflächen hoher Güte zu erhalten, ist es üblich, zwischen den mit einer Seite hoher Güte an den Außenseiten der Pakete anliegenden Preßblechen und den Heizplatten einer Heizpresse Druckausgleichspolster einzusetzen, die eine gewisse Elastizität haben. In der Patentliteratur werden eine Vielzahl von verschiedenen Druckausgleichspolstern vorgeschlagen, die aus Baumwoll- und/oder Asbestgeweben oder aus einem Metallfaserflies (DE-OS 22 30 220) oder aus einem Metallsiebgewebe mit wärmeleitfähigem Füllmaterial (DE-OS 23 19 593) bestehen. Solche Druckausgleichspolster sollen nicht nur den Druck ausgleichen, sondern auch die von der Heizplatte auf das Paket zu übertragende Wärme vergleichmäßigen und puffern. Alle diese Druckausgleichspolster haben in der Praxis keine Bedeutung erlangt. In der Praxis erreicht man nach wie vor die besten Ergebnisse mit einem Druckausgleichspolster, das aus einem Paket von 30 bis 40 Blatt lose übereinandergelegten Lagen aus Natronkraftpapier besteht. Solche Druckausgleichspolster führen zu einem zufriedenstellenden Druck- und Hitzeausgleich und sorgen dafür, daß die von den Heizplatten ausgehende Wärme nicht schlagartig am zu verpressenden Paket wirksam wird. Nachteilig beim Einsatz solcher Druckausgleichspolster ist der mit der Zusammenstellung der Papierpakete verbundene Aufwand und die Tatsache, daß solche Druckausgleichspolster wegen ihres Verlustes an Elastizität beim Verpressen bestimmter Materialien und/oder nach bestimmten Preßprogrammen nur einmal verwendet werden können und anschließend entsorgt werden müssen.

In Kenntnis dieser Problematik sind seit langem Bestrebungen im Gange, mehrfach verwendbare Druckausgleichspolster zu schaffen, mit denen die gewünschte Wärmeübertragung erreicht werden kann.

Der Erfindung liegt die Aufgabe zugrunde, ein Verfahren der eingangs genannten Art zu schaffen, das mit geringerem Aufwand als die bekannten Verfahren durchgeführt werden kann.

Diese Aufgabe wird dadurch gelöst, daß als Druckausgleichspolster ein einlagiger Doppelstoff aus Baumwolle verwendet wird, der nach mehrmaligem Gebrauch als Zwischenlage zwischen den mit Kunstharz getränkten Materiallagen aus Baumwolle oder Papier des zu verpressenden Paketes eingesetzt wird.

Es wurde gefunden, daß mit einem einlagigen Doppelstoff aus Baumwolle die angestrebte vergleichmäßigte, gepufferte Wärmeübertragung von den Heizplatten auf das zu verpressende Paket bei gutem Druckausgleich erreicht wird. Auch bei mehrmaligem Einsatz als Druckausgleichspolster hat der Doppelstoff noch eine ausreichende Elastizität, um druckausgleichend zu wirken. Reicht die Druckausgleichseigenschaft des Doppelstoffes nicht mehr aus, dann wird er in einem Paket mit Kunstharz getränkten Materiallagen verpreßt. Damit ist auch das sonst bestehende Entsorgungsproblem auf elegante Art und Weise gelöst.

Nach einer Ausgestaltung der Erfindung sollten die Materiallagen bei einem eine Zwischenlage aus Doppelstoff aufweisenden Paket mehr Kunstharz als bei einem zwischenlagenfreien Paket enthalten. Dabei dürfte es ausreichen, wenn die der Zwischenlage benachbarten Materiallagen mehr Kunstharz als die anderen Materiallagen enthalten. Dieser Überschuß an Kunstharz dient dazu, beim Verpressen auch die kunstharzfreie Zwischenlage vollständig mit Kunstharz zu tränken.

Gegenstand der Erfindung ist ferner ein Druckausgleichspolster für die Durchführung des Verfahrens, das aus einem einlagigen Doppelstoff aus Baumwolle besteht. In Versuchen wurde gute Ergebnisse mit einem Doppelstoff mit einem Gewicht von 370 g/m² und einer Dicke von 0,75 mm erzielt, wobei das Verpressen mit Preßdrücken bis zu 100 Bar bei einer Temperatur bis zu 180 ° C und einer Preßzeit bis zu 180 min. erfolgt.

Im folgenden wird die Erfindung anhand einer Zeichnung näher erläutert.

Ein zu verpressendes Paket 3 ist zwischen Heizplatten 1,2 einer Heizpresse angeordnet. Das Paket 3 besteht aus einer Vielzahl von harzgetränkten Materiallagen 4,5 aus Papier und einer in der Mitte angeordneten Lage 6 aus einem Doppelstoff aus Baumwollgewebe. Die Außenseiten des Paketes 3 sind mit Kupferfolie 7,8 als Kaschierung für das Paket 3 abgedeckt. Auf den Kupferfolien 7,8 liegen Preßbleche 9,10 mit hochglatten Oberflächen auf. Zwischen den Preßblechen 9,10 und den Heizplatten 1,2 sind Druckausgleichspolster 11,12 aus einem einlagigen Doppelstoff aus Baumwolle angeordnet. Der Doppelstoff der Druckausgleichspolster 11,12 ist wesentlich dicker als der Doppelstoff der Zwischenlage, weil die Druckausgleichspolster 11,12 noch nicht oder erst wenige Male verpreßt worden sind, während der Doppelstoff der Zwischenlage 6 schon mehrmals verpreßt worden ist und deshalb seine Druckausgleichsqualität verloren hat. Er kann deshalb nur als Zwischenlage beim Verpressen des Paketes 3 verbraucht werden. Damit dies möglich ist, muß er zwischen harzreichen Lagen beim Verpressen liegen.

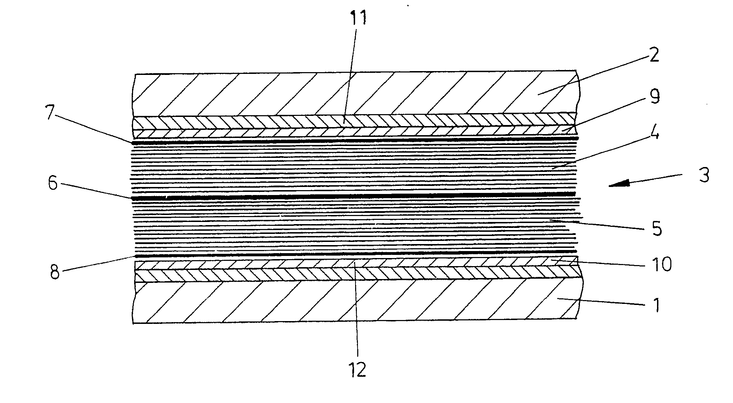

**Patentansprüche**

1. Verfahren zum Verpressen von Paketen (3) aus mit härtbarem Kunstharz getränkten Materiallagen (4,5) und gegebenenfalls einer oder zwei Decklagen (7,8) aus Kupferfolie zwischen mit Druckausgleichspolstern (11,12) versehenen Preßblechen (9,10) unter Zufuhr von Wärme zu Platten,
   **dadurch gekennzeichnet,** daß als Druckausgleichspolster (11,12) ein einlagiger Doppelstoff aus Baumwolle verwendet wird, der nach mehrmaligem Gebrauch als Zwischenlage (6) zwischen den mit Kunstharz getränkten Materiallagen (4,5) des zu verpressenden Paketes (3) eingesetzt wird.

2. Verfahren nach Anspruch 1,
   **dadurch gekennzeichnet,** daß die Materiallagen (4,5) bei einem eine Zwischenlage (6) aus Doppelstoff aufweisenden Paket (3) mehr Kunstharz als bei einem zwischenlagenfreien Paket enthalten.

3. Verfahren nach Anspruch 2,
   **dadurch gekennzeichnet,** daß die der Zwischenlage (6) benachbarten Materiallagen mehr Kunstharz als die anderen Materiallagen enthalten.

4. Druckausgleichspolster für die Durchführung eines Verfahrens zum Verpressen von Paketen aus mit härtbarem Kunstharz getränkten Materiallagen zwischen Preßblechen unter Zufuhr von Wärme zu Platten, insbesondere zur Durchführung des Verfahrens nach einem der Ansprüche 1 bis 3,
   **dadurch gekennzeichnet,** daß das Druckausgleichspolster aus einem einlagigen Doppelstoff aus Baumwolle besteht.

5. Druckausgleichspolster nach Anspruch 4,
   **dadurch gekennzeichnet,** daß der Doppelstoff ein Gewicht von 200 bis 500 g/m$^2$, insbesondere 370 g, hat.